# FASCICULE DE BREVET EUROPEEN

(11) **EP 1 422 271 B1**
(45) Date de publication et mention de la délivrance du brevet: **26.04.2006**
(21) Numéro de dépôt: 03104279.9
(22) Date de dépôt: 19.11.2003
(51) Int. Cl.: C09D 7/12, C09D 5/20, C09D 175/04, B64G 1/54, G03C 1/38, G03C 1/85, C09D 133/06, G03G 5/02, C08J 9/00, C08K 3/04, C09D 5/24, H01B 1/24, H05K 9/00

(54) **Materiaux de protection électrostatique et leurs utilisations**
Materialien zum Schutz gegen elektrostatische Effekte und Verwendungen derselben
Materials for electrostatic protection and their uses

(30) Priorité: 19.11.2002 FR 0214435
(43) Date de publication de la demande: 26.05.2004
(73) Titulaire: Cryospace l'air liquide aerospatiale, 78133 Les Mureaux Cédex (FR)
(72) Inventeur: Cargnello, Remo, 78130, Les Mureaux (FR); Borromee, Alain, 78150, Le Chesnay (FR)
(74) Mandataire: Poulin, Gérard

(56) Documents cités:
- EP-A- 1 296 182
- EP-A- 1 296 183
- WO-A-91/03520
- US-A- 4 818 437
- US-A- 4 889 750
- US-A- 5 262 474

## Description

### DOMAINE TECHNIQUE

La présente invention se rapporte à des matériaux de protection électrostatique ainsi qu'à leurs utilisations.

Plus précisément, elle se rapporte à l'utilisation d'agents tensio-actifs cationiques en tant qu'additifs antistatiques, à une composition utile pour la réalisation de revêtements de protection électrostatique de type peintures ou vernis contenant un tel additif, ainsi qu'à une peinture obtenue à partir de cette composition.

Ces matériaux sont plus spécialement destinés à être utilisés dans les industries aéronautique et spatiale, pour faciliter l'écoulement des charges électrostatiques sur la surface externe des avions et des engins spatiaux, et notamment des lanceurs, et les protéger ainsi des phénomènes de décharges électriques, que ce soit au sol ou en vol. En particulier, ces matériaux sont utiles pour conférer une protection électrostatique à des structures cryogéniques comme les réservoirs.

Toutefois, ils peuvent également être employés dans tout autre secteur industriel dans lequel la survenue de décharges électriques est susceptible de mettre en danger les équipements et le personnel comme, par exemple, l'industrie pétrolière pour la protection des plate-formes, ou l'industrie chimique, pour supprimer les risques d'explosion et d'incendie, en particulier dans les usines de fabrication de poudres, explosifs et de produits inflammables.

### ETAT DE LA TECHNIQUE ANTERIEURE

L'utilisation de matériaux diélectriques (composites ou plastiques) dans la fabrication d'engins spatiaux favorise l'accumulation de charges électrostatiques à la surface de ces engins par effet triboélectrique.

Lorsque la quantité de charges électrostatiques accumulées est trop importante, des décharges électriques peuvent se produire et les perturbations électromagnétiques ainsi générées sont susceptibles de provoquer un dysfonctionnement des instruments de navigation et autres systèmes électriques.

Il est donc indispensable de munir la surface externe des engins spatiaux d'un revêtement de protection électrostatique qui doit assurer, d'une part, l'écoulement des charges électrostatiques accumulées sans créer d'interférences électromagnétiques et, d'autre part, une équipotentialité de surface quels que soient les matériaux sous-jacents.

Pour le lanceur ARIANE V par exemple, la spécification de résistivité surfacique est telle que cette résistivité doit être comprise entre 10⁵ et 10⁹ Ω/carré et doit se maintenir dans cette fourchette jusqu'à une altitude de 15 km après le décollage. Cette contrainte en engendre deux autres : une contrainte thermique d'une part, qui réside dans une augmentation de la température de la surface externe du lanceur qui peut atteindre environ 100°C, et une contrainte de pression d'autre part, cette dernière chutant en effet jusqu'à atteindre une valeur de 120 mbars absolus.

Actuellement, une résistivité surfacique répondant à la spécification précédemment mentionnée est obtenue avec des compositions de peinture polyuréthanne formulées spécialement pour l'industrie spatiale et dont la fonctionnalité anti-électrostatique est assurée par une charge minérale composée de dioxyde de titane et d'oxydes métalliques.

Ces compositions sont préparées juste avant d'être appliquées, en mélangeant une base polyuréthanne dans laquelle se trouve la charge minérale, et un durcisseur. Le temps de mûrissement du mélange ainsi obtenu est d'environ 30 minutes à 20°C et sa durée de vie en pot (ou "pot-life") est d'environ 2 heures pour une quantité d'1 kg, à 20°C et dans des conditions d'hygrométrie relative de 50%. Elles sont appliquées par pulvérisation, en veillant à ce que la quantité de masse sèche déposée par m² de surface soit comprise entre 60 à 110 grammes selon la nature du support sur lequel se fait cette application.

En dépit de leurs bonnes caractéristiques électriques, ces compositions ne donnent pas totalement satisfaction. En effet, elles présentent l'inconvénient d'avoir une mise en oeuvre contraignante, de par le fait que des paramètres doivent impérativement être respectés pour garantir l'exigence de résistivité surfacique, d'avoir une tenue au froid médiocre, un pot-life de très courte durée et une densité élevée en raison de la présence des oxydes métalliques. Or, l'industrie spatiale étant sans cesse à la recherche d'économies de poids, il est souhaitable que les matériaux qui lui sont destinés soient les moins denses possible.

Ces compositions ont aussi le défaut d'être très onéreuses et ce, d'autant qu'il est fortement déconseillé de les appliquer en fin de pot-life (c'est-à-dire, en pratique, au-delà d'1 heure et demi après le mélange de la base et du durcisseur) car la résistivité surfacique augmente très rapidement, ce qui grève encore leur coût.

Enfin, les peintures obtenues avec ces compositions présentent généralement des propriétés mécaniques de souplesse et de résistance à l'arrachemment relativement limitées qui les rendent impropres à certaines utilisations. Ainsi, par exemple, elles conviennent mal aux réservoirs cryogéniques qui, d'une part, sont amenés à subir des contractions sous l'effet de la température et des dilatations sous l'effet de la pression et, d'autre part, sont revêtus de matériaux d'isolation thermique, du type mousse rigide de polyuréthanne (auquel cas, l'isolation est dite "froide") ou de liège (auquel cas, l'isolation est dite "chaude"), que l'on usine une fois appliqués sur la surface de ces réservoirs et dont les particules, ainsi produites par cet usinage, réduisent l'adhérence des revêtements anti-électrostatiques.

Les Inventeurs se sont donc fixé pour but de fournir des compositions qui permettent de réaliser des revêtements de protection électrostatique de type peintures ou vernis satisfaisant aux spécifications de résistivité surfacique en usage dans l'industrie spatiale, et notamment pour les lanceurs spatiaux, tout en étant exemptes des inconvénients présentés par les compositions de peinture antistatique utilisées actuellement dans ce secteur.

En particulier, les Inventeurs ont cherché à ce que ces compositions soient simples à mettre en oeuvre, soient utilisables sur tout type de supports et de structures, et notamment sur des structures cryogéniques, et à ce qu'elles soient, en outre, le moins onéreuses possible.

Ces buts sont atteints par la présente invention qui propose l'utilisation d'agents tensio-actifs cationiques en tant qu'additifs antistatiques, une composition utile pour réaliser une peinture ou un vernis de protection électrostatique et une peinture obtenue à partir de cette composition.

EP-A-1 296 182 et EP-A-1 296 183, qui ne font partie de l'état de la technique opposable à la présente invention qu'au titre de l'article 54(3) CBE et que pour les seuls Etats contractants DE et GB, décrivent des compositions aqueuses qui renferment un agent tensio-actif et qui sont destinées à former des revêtements sur des films et papiers photographiques en vue de les protéger d'une accumulation de charges électrostatiques au cours de leur fabrication et de leur utilisation.

### EXPOSÉ DE L'INVENTION

L'invention a, en premier lieu, pour objet :
- pour tous les Etats contractants désignés autres que DE et GB : l'utilisation, dans une composition filmogène, d'au moins un agent tensio-actif cationique pour conférer une résistivité surfacique de 10⁵ à 10⁹ Ω/carré à une peinture ou à un vernis obtenu par application et séchage de ladite composition sur un support ; et
- pour les Etats contractants DE et GB : l'utilisation, dans une composition filmogène, d'au moins un agent tensio-actif cationique en solution dans un solvant organique pour conférer une résistivité surfacique de 10⁵ à 10⁹ Ω/carré à une peinture ou à un vernis obtenu par application et séchage de ladite composition sur un support.

Dans le cadre de leurs travaux, les Inventeurs ont, en effet, constaté que, de manière surprenante, le fait d'inclure dans une composition filmogène, dans des proportions convenablement choisies, un ou plusieurs agents tensio-actifs cationique, permet de conférer aux revêtements de type peintures ou vernis résultant de l'application et du séchage de cette composition sur des supports, une résistivité surfacique qui s'inscrit dans la plage des valeurs de résistivité surfacique auxquelles doivent satisfaire les revêtements de protection électrostatique des lanceurs spatiaux, et qui se maintient dans cette plage lorsque lesdits revêtements sont soumis à une température de 15 à 250°C, une hygrométrie relative de 0 à 90% et une pression comprise entre la pression atmosphérique (1 bar) et 120 mbars absolus et ce, quelle que soit la nature (composite, plastique, métallique, ...) de ces supports.

Il convient de noter que l'utilisation d'agents tensio-actifs cationiques en tant qu'additifs antistatiques n'est pas nouvelle en soi.

Ainsi, par exemple, il est connu, dans les secteurs de l'automobile et de l'électroménager, d'utiliser des amines éthoxylées à chaîne grasse comme agents anti-statiques dans des mélanges-maîtres de polyoléfines (polyéthylène ou polypropylène) ou de polymères styréniques du type ABS ou polystyrène, pour faciliter l'écoulement des charges électriques et éviter l'attraction des poussières sur les objets fabriqués par moulage à partir de ces mélanges-maîtres.

Par contre, ce qui est nouveau et inattendu est le fait que leur utilisation - en solution dans un solvant organique pour les Etats contractants DE et GB - dans des compositions filmogènes conduise à des revêtements qui répondent aux spécifications de résistivité surfacique définies pour les revêtements de protection électrostatique des lanceurs spatiaux et ce, quels que soient les matériaux sur lesquels ces revêtements sont réalisés.

De plus, il s'avère que la présence d'un ou plusieurs agents tensio-actifs cationiques dans des compositions filmogènes confère de la souplesse aux revêtements obtenus à partir de ces compositions, contrairement aux charges minérales. Ainsi, ces revêtements présentent une bonne tenue au froid et une résistance très satisfaisante aux contractions thermiques et aux dilatations sous pression qui leur confère un intérêt tout particulier dans le domaine cryotechnique.

Conformément à l'invention, le ou les agents tensio-actifs cationiques sont, de préférence, choisis dans le groupe constitué par les sels d'ammonium quaternaire, et plus spécialement parmi les éthosulfates de N-alkyldiméthyléthylammonium issus d'acides gras de coco.

Pour tous les Etats contractants désignés autres que DE et GB, ce ou ces agents tensio-actifs cationiques sont, par ailleurs, préférentiellement utilisés, c'est-à-dire ajoutés à la composition filmogène, en solution dans un solvant organique, de manière à obtenir un mélange agent(s) tensio-actif(s)/composition filmogène le plus homogène possible.

Ce solvant organique peut être choisi parmi les très nombreux solvants organiques commercialement disponibles, sous réserve qu'il soit, d'une part, apte à dissoudre complètement ledit ou lesdits agents tensio-actifs et, d'autre part, compatible avec les autres constituants de la composition filmogène.

Ainsi, on peut utiliser, à titre indicatif, un hydrocarbure aromatique comme le toluène, le xylène ou le styrène, un hydrocarbure aliphatique comme le white spirit, une cétone comme la méthyléthylcétone ou la méthylisobutylcétone, un ester comme l'acétate d'éthyle ou l'acétate d'éthyle, un alcool comme le propanol ou le butanol, un éther de glycol comme l'éthylglycol et le butylglycol, un hydrocarbure terpénique comme l'essence de térébenthine, ainsi qu'un mélange de plusieurs de ces solvants.

De préférence, le solvant organique est choisi parmi les alcools, les éthers de glycol et leurs mélanges.

Lorsque le ou les agents tensio-actifs cationiques sont utilisés en solution dans un solvant organique, alors ils représentent au moins 50% (p/p) et, mieux encore, au moins 70% (p/p) de cette solution.

Des solutions prêtes à l'emploi, comprenant un agent tensio-actif cationique ou un mélange d'agents tensio-actifs cationiques dans un solvant organique, peuvent très bien être utilisées dans le cadre de la présente invention.

Ainsi, par exemple, la solution d'éthosulfates de N-alkylcocodiméthyléthylammonium à environ 80% (p/p) dans un mélange butanol/éthylglycol, qui est commercialisée par la Société CECA sous la référence NORAMIUM® CES 80, s'est révélée convenir particulièrement bien à la mise en oeuvre de l'invention.

Quelle que soit la forme sous laquelle le ou les agents tensio-actifs cationiques sont utilisés, ils sont ajoutés à la composition filmogène en une quantité permettant d'ajuster la résistivité surfacique des revêtements destinés à être obtenus à partir de cette composition à la valeur désirée. Cette quantité est susceptible de varier dans de larges proportions en fonction de l'agent ou des agents tensio-actifs utilisés et de la nature des autres constituants de ladite composition.

L'invention a également pour objet une composition utile pour la réalisation d'une peinture ou d'un vernis de protection électrostatique, caractérisée en ce qu'elle comprend un liant filmogène et au moins un agent tensio-actif cationique dans un solvant organique.

Dans le cadre de la présente invention, le terme "filmogène", appliqué à une composition ou à un liant, signifie que cette composition ou ce liant est apte à former, par application en une ou plusieurs couches sur un support et séchage, une pellicule continue, dure et adhérente audit support.

Le liant filmogène peut être n'importe quel liant mono-composant ou bi-composant, connu comme étant utile dans des formulations de peinture ou de vernis. On peut citer, à titre d'exemples non-limitatifs, les liants polyuréthannes, les résines époxydes, les résines acryliques, les résines glycérophtaliques et les résines vinyliques.

De préférence, le liant filmogène est un liant polyuréthanne bi-composant, c'est-à-dire comprenant une base et un durcisseur destinés à être mélangés juste avant emploi de ladite composition, le ou les agents tensio-actifs cationiques étant, préférentiellement, présents dans la base.

En effet, outre que les compositions à base de liants polyuréthannes sont simples à mettre en oeuvre, les peintures ou vernis obtenus à partir de ces compositions présentent généralement des propriétés d'adhérence et une tenue au vieillissement qui les rendent bien adaptées à l'industrie spatiale.

Là également, le ou les agents tensio-actifs cationiques sont, de préférence, choisis dans le groupe constitué par les sels d'ammonium quaternaire, et plus spécialement parmi les éthosulfates de N-alkyldiméthyléthylammonium issus d'acides gras de coco, et sont préférentiellement ajoutés au liant filmogène sous la forme d'une solution dans un solvant organique, avantageusement un alcool, un éther de glycol ou un mélange de ceux-ci. Dans ce cas, la composition comprend, donc, également un solvant organique qui correspond au solvant apporté par la solution d'agent(s) tensio-actif (s) .

Selon un mode de réalisation préféré de la composition, celle-ci comprend, pour 100 parties en poids d'une base polyuréthanne :
- de 70 à 110 parties en poids et, de préférence, de 80 à 100 parties en poids d'une solution d'éthosulfates de N-alkylcocodiméthyléthylammonium à environ 80% (p/p) dans un mélange butanol/éthylglycol, et
- de 80 à 110 parties en poids et, de préférence, de 90 à 100 parties en poids d'un durcisseur polyuréthanne.

La composition selon l'invention peut comprendre, de plus, un ou plusieurs adjuvants propres à lui conférer ou à conférer à la peinture ou au vernis de protection électrostatique obtenu à partir de cette composition des propriétés particulières.

Ce ou ces adjuvants peuvent être choisis parmi les nombreux adjuvants classiquement utilisés dans des formulations de peinture ou de vernis, pour autant qu'ils ne dégradent pas les autres propriétés de la composition, de la peinture ou du vernis, et en particulier la résistivité surfacique et la souplesse de cette peinture ou de ce vernis.

Ainsi, lorsque la composition est destinée à être appliquée sur la surface externe de lanceurs spatiaux, elle comprend avantageusement au moins un pigment blanc en quantité appropriée pour conférer à la peinture ou au vernis une bonne stabilité aux ultraviolets, un facteur d'absorption solaire au plus égal à 0,65 et une émissivité infrarouge proche de 0,90, ces spécifications jouant, en effet, un rôle important pour le dimensionnement thermique des revêtements d'isolation "chaude" et "froide" appliqués sur les structures porteuses comme, par exemple, les réservoirs cryogéniques.

Autant que possible, ce ou ces pigments blancs ne sont pas choisis parmi les oxydes métalliques, de manière à éviter que leur présence dans la composition ne se traduise par une augmentation trop importante de la densité de cette dernière.

Des pigments blancs convenant à la réalisation d'une composition selon l'invention sont, par exemple, les carbonates de calcium naturels comme le blanc de Meudon.

Dans le cas où le liant filmogène est un liant polyuréthanne se composant d'une base et d'un durcisseur devant être mélangés juste avant emploi, alors le ou les pigments blancs sont, de préférence, présents dans la base, avantageusement à hauteur de 10 à 30 parties en poids.

La composition selon l'invention peut être préparée en incorporant dans le liant filmogène (si celui-ci est mono-composant) ou dans la base du liant filmogène (si celui-ci est bi-composant) et après avoir homogénéisé ce liant ou cette base, le ou les agents tensio-actifs cationiques, préférentiellement sous la forme d'une solution dans un solvant organique, puis le ou les éventuels adjuvants (pigments blancs notamment), et en malaxant l'ensemble jusqu'à obtenir un mélange parfaitement homogène.

La composition ou la base ainsi obtenue peut alors être conditionnée dans des récipients hermétiques comme des pots, pour son transport et son stockage, le durcisseur (dans le cas d'un liant filmogène bi-composant) étant, lui, conditionné dans des récipients séparés.

Lorsque la composition selon l'invention comprend un liant filmogène bi-composant, alors son utilisation nécessite un mélange préalable de la base et du durcisseur, qui est réalisé juste avant emploi de cette composition. Le mélange résultant doit subir un mûrissement d'une quinzaine de minutes environ à température ambiante (c'est-à-dire, en pratique, à une température de 18 à 24°C) et sous une hygrométrie relative inférieure à 60%, au terme desquelles il est de nouveau homogénéisé.

Il est alors prêt à être appliqué sur un support. Bien que l'on puisse recourir, pour ce faire, à toute technique d'application utilisée pour les compositions de peinture et de vernis, la composition selon l'invention se prête particulièrement bien, de par sa viscosité, à une pulvérisation, laquelle est, par exemple, réalisée au moyen d'un pistolet pneumatique.

De préférence, la composition est appliquée sur le support à température ambiante et sous une hygrométrie relative inférieure à 60%, les Inventeurs ayant, en effet, constaté que ces conditions conduisent à une optimisation des propriétés anti-électrostatiques des revêtements résultants. Pour les mêmes raisons, le séchage de la composition ainsi appliquée est, lui aussi, effectué de préférence à température ambiante et sous une hygrométrie relative inférieure à 60%.

Le dépôt d'une seule couche de quelques microns d'épaisseur, de l'ordre de 10 à 50 µm, de la composition selon l'invention suffit en principe à obtenir une peinture ou un vernis de protection électrostatique dont la résistivité surfacique est comprise entre 0,1 et 10³ MΩ/carré, ce qui, d'une part, favorise l'adhérence de ce revêtement sur son support et, d'autre part, permet de limiter au maximum le poids de ce revêtement, ce qui est extrêmement appréciable pour des applications spatiales ou aéronautiques. Il est, toutefois, possible, si on le souhaite d'appliquer la composition selon l'invention en une couche plus épaisse ou en plusieurs couches.

Ainsi, il n'est pas nécessaire, avec la composition selon l'invention, d'enduire préalablement le support d'une sous-couche d'accrochage destinée à augmenter l'adhérence du revêtement sur ce support.

Par ailleurs, même lorsque cette composition est appliquée sur un matériau susceptible de perdre des particules comme une mousse rigide de polyuréthanne, il n'est pas non plus nécessaire de recouvrir le revêtement résultant, une fois sec, d'un produit de colmatage destiné à limiter les risques de pollution générée par la perte de ces particules. Il suffit, en effet, de déposer une couche de composition d'épaisseur suffisante pour noyer dans cette couche toutes les cellules et les fibres apparentes à la surface du matériau.

La composition selon l'invention présente donc de nombreux avantages.

En effet, outre qu'elle permet d'obtenir des peintures ou vernis de protection électrostatique extrêmement satisfaisants, tant en termes de résistivité surfacique, d'émissivité infrarouge, d'absorption solaire, d'adhérence vis-à-vis des supports qu'ils recouvrent, de tenue au vieillissement, de souplesse et, partant, de tenue au froid et de résistance aux contractions thermiques et aux dilatations sous pression, et ce, quels que soient les matériaux sous-jacents, elle est simple à fabriquer et elle est simple à mettre en oeuvre.

Par ailleurs, elle est économiquement très intéressante et ce, pour trois raisons. D'une part, elle est susceptible d'être préparée à partir de matières premières de coût raisonnable. D'autre part, les agents tensio-actifs cationiques se caractérisant par une masse volumique relativement peu élevée, elle présente une densité notablement plus faible que celle des compositions de peinture antistatique contenant une charge minérale. Ainsi, elle permet, non seulement de réaliser des peintures ou vernis moins denses, mais également de couvrir, pour une même masse sèche déposée, une plus grande surface de support. Enfin, elle est utilisable jusqu'au terme de son pot-life, lequel s'est avéré pouvoir être de 8 heures.

L'invention a encore pour objet une peinture de protection électrostatique, caractérisée en ce qu'elle est obtenue par application et séchage sur un support d'une ou plusieurs couches d'une composition telle que précédemment définie.

De manière préférée, l'application et le séchage sur le support de la ou des couches de ladite composition sont réalisées à une température de 18 à 24°C et sous une hygrométrie relative inférieure à 60%.

Avantageusement, cette peinture de protection électrostatique présente une résistivité surfacique de 10⁵ à 10⁹ Ω/carré.

D'autres caractéristiques et avantages de l'invention apparaîtront mieux à la lecture de la description qui suit, qui se rapporte à un exemple de réalisation d'une composition conforme à l'invention et de démonstration des propriétés des peintures obtenues à partir de cette composition, et qui est donné à titre illustratif et en aucun cas limitatif.

### EXPOSÉ DÉTAILLÉ D'UN EXEMPLE DE RÉALISATION

On a préparé une composition de peinture de protection électrostatique conforme à l'invention en opérant comme suit.

On a mélangé tout d'abord 100 parties en poids d'une base polyuréthanne (AERODUR® FINISH C21/100 UVR - AKZO NOBEL) de manière à la rendre parfaitement homogène, puis on a ajouté à cette base, successivement et tout en continuant de mélanger :
- 80 parties en poids d'une solution d'éthosulfates de N-alkylcocodiméthyléthylammonium à environ 80% (p/p) dans un mélange butanol/éthylglycol (NORAMIUM® CES 80 - CECA),
- 15 parties en poids d'un carbonate de calcium naturel en poudre (PROLABO), et
- 90 parties en poids d'un durcisseur polyuréthanne (AERODUR FINISH S66/22R - AKZO NOBEL).

Le mélange a été poursuivi jusqu'à obtention d'une composition totalement homogène.

On a laissé cette composition mûrir pendant 15 minutes à 20°C, au terme desquelles elle a de nouveau été homogénéisée.

On a ainsi obtenu une composition de densité proche de 1 et de pot-life d'environ 8 heures à température ambiante (18-24°C), et sous hygrométrie relative inférieure à 60°C.

Les propriétés de résistivité surfacique et d'émissivité infrarouge (IR) de peintures obtenues à partir de cette composition ont été testées sur différents types de support.

Pour ce faire, la composition a été appliquée par pulvérisation et sous atmosphère contrôlée (20°C, hygrométrie relative < 60%) sur des éprouvettes carrées, mesurant 15 cm de côté et respectivement constituées :
- d'une mousse rigide de polychlorure de vinyle (PVC),
- d'une mousse rigide de polyuréthanne (PUR),
- de liège,
- d'un matériau isolant formé d'un élastomère chargé en silice, comme décrit dans FR-A-95 04097 [1], et
- d'un alliage d'aluminium type 2024.

Les mousses rigides de PVC et de polyuréthanne, le liège ainsi que l'élastomère chargé en silice ont été choisis comme supports car ce sont des matériaux classiquement utilisés comme revêtements d'isolation thermique sur les réservoirs cryogéniques des lanceurs spatiaux. Quant à l'alliage d'aluminium, il est couramment employé dans l'industrie aéronautique.

Les applications ont été réalisées de sorte que soit déposée une masse sèche de composition de 85 g/m² sur chaque éprouvette.

La spécification de résistivité surfacique des revêtements destinés au lanceur ARIANE V exigeant le maintien d'une résistivité comprise entre 0,1 et 10³ MΩ/carré à une température d'environ 100°C, les éprouvettes, ont été soumises, après séchage de la composition, à un chauffage en étant placées, soit directement sur une plaque chauffante pour les éprouvettes constituées d'un matériau conducteur de chaleur (aluminium), soit dans une étuve chauffée pour les éprouvettes constituées d'un matériau thermiquement isolant (mousses de PVC et de polyuréthanne, liège, élastomère chargé en silice).

La résistivité surfacique (Rₛ) des différentes peintures a été mesurée au moyen d'un mégohmmètre SEFELEC M500 muni d'électrodes en cuivre et sous une tension de mesure de 500 volts continus, tandis que leur émissivité infrarouge a été déterminée à l'aide d'un thermomètre IR à émissivité réglable TASCO THI-300.

Les résultats sont présentés dans le tableau 1 ci-après.

**TABLEAU 1**

| **Support** | **Température (°C)** | **R**_{**s**} **(MΩ/carré)** | **Emissivité IR** |
|---|---|---|---|
| Mousse PVC | 110 | 0,1<Rₛ<100 | 0,85 |
| Mousse PUR | 110 | 0,1<Rₛ<100 | 0,85 |
| Liège | 200 | 0,1<Rₛ<100 | 0,88 |
| Elastomère chargé en Si | 200 | 0,1<Rₛ<100 | 0,88 |
| Aluminium | 200 | 0,1<Rₛ<10 | 0,88 |

Ce tableau montre que les peintures obtenues à partir d'une composition conforme à l'invention présentent, même lorsqu'elles sont portées à des températures supérieures à 100°C, une résistivité surfacique entrant dans la gamme des valeurs de résistivité exigées pour le lanceur ARIANE V et ce, quel que soit le support sur lequel elles se trouvent. De plus, aucune détérioration de ces peintures n'a été notée à de telles températures.

Ces peintures présentent, par ailleurs, une émissivité infrarouge proche de 0,9.

Les éprouvettes ont aussi été soumises à un vide de 900 mbars de dépression. La résistivité surfacique des peintures a alors varié de façon insignifiante.

Des tests menés en parallèle en utilisant une composition de peinture antistatique polyuréthanne contenant une charge minérale telle qu'actuellement utilisée dans l'industrie spatiale, ont permis d'obtenir des peintures qui présentent également une résistivité surfacique répondant à la spécification des revêtements destinés au lanceur ARIANE V, mais sans montrer de meilleurs résultats.

Par contre, cette résistivité n'a pu être obtenue qu'en déposant sur les différentes éprouvettes une masse sèche de 110 g/m², c'est-à-dire 1,3 fois plus élevée que la masse sèche de composition selon l'invention devant être déposée pour obtenir les mêmes résultats.

## Revendications (Revendications pour l'(les) Etat(s) contractant(s) suivant(s): DE, GB)

1. Utilisation, dans une composition filmogène, d'au moins un agent tensio-actif cationique en solution dans un solvant organique pour conférer une résistivité surfacique de 10⁵ à 10⁹ Ω/carré à une peinture ou un vernis obtenu par application et séchage de ladite composition sur un support;

2. Utilisation selon la revendication 1, dans laquelle le ou les agents tensio-actifs cationiques sont choisis dans le groupe constitué par les sels d'ammonium quaternaire.

3. Utilisation selon la revendication 1 ou la revendication 2, dans laquelle le ou les agents tensio-actifs cationiques sont choisis parmi les éthosulfates de N-alkylcocodiméthyléthylammonium.

4. Utilisation selon la revendication 1, dans laquelle le solvant organique est choisi parmi les alcools, les éthers de glycol et leurs mélanges.

5. Utilisation selon la revendication 1 ou la revendication 4, dans laquelle le ou les agents tensioactifs cationiques représentent au moins 50% (p/p) et, de préférence, au moins 70% (p/p) de la solution dans laquelle ils se trouvent.

6. Utilisation selon la revendication 4 ou la revendication 5, dans laquelle on utilise une solution d'éthosulfates de N-alkylcocodiméthyléthylammonium à environ 80% (p/p) dans un mélange butanol/éthylglycol.

7. Composition utile pour la réalisation d'une peinture ou d'un vernis de protection électrostatique, **caractérisée en ce qu'**elle comprend un liant filmogène et au moins un agent tensio-actif cationique dans un solvant organique.

8. Composition selon la revendication 7, **caractérisée en ce que** le liant filmogène est un liant polyuréthanne à deux composants : une base et un durcisseur, qui sont destinés à être mélangés juste avant emploi de ladite composition, le ou les agents tensio-actifs cationiques étant présents dans la base.

9. Composition selon la revendication 7 ou la revendication 8, **caractérisée en ce que** le ou les agents tensio-actifs cationiques sont choisis dans le groupe constitué par les sels d'ammonium quaternaire.

10. Composition selon l'une quelconque des revendication 7 à 9, **caractérisée en ce que** le ou les agents tensio-actifs cationiques sont choisis parmi les éthosulfates de N-alkylcocodiméthyléthylammonium.

11. Composition selon l'une quelconque des revendications 7 à 10, **caractérisée en ce que** le ou les agents tensio-actifs cationiques sont ajoutés au liant filmogène sous la forme d'une solution dans un solvant organique.

12. Composition selon la revendication 11, **caractérisée en ce que** le solvant organique est choisi parmi les alcools, les éthers de glycol et leurs mélanges.

13. Composition selon l'une quelconque des revendications 8 à 12, **caractérisée en ce qu'**elle comprend, pour 100 parties en poids d'une base polyuréthanne :
- de 70 à 110 parties en poids d'une solution d'éthosulfates de N-alkylcocodiméthyléthylammonium à environ 80% (p/p) dans un mélange butanol/éthylglycol, et
- de 80 à 110 parties en poids d'un durcisseur polyuréthanne.

14. Composition selon la revendication 13, **caractérisée en ce qu'**elle comprend, pour 100 parties en poids d'une base polyuréthanne :
- de 80 à 100 parties en poids d'une solution d'éthosulfates de N-alkylcocodiméthyléthylammonium à environ 80% (p/p) dans un mélange butanol/éthylglycol, et
- de 90 à 100 parties en poids d'un durcisseur polyuréthanne.

15. Composition selon l'une quelconque des revendications 7 à 14, **caractérisée en ce qu'**elle comprend au moins un pigment blanc.

16. Composition selon la revendication 15, **caractérisée en ce que** le pigment blanc est un carbonate de calcium naturel.

17. Peinture de protection électro-statique, **caractérisée en ce qu'**elle est obtenue par application et séchage sur un support d'une ou plusieurs couches d'une composition telle que définie dans l'une quelconque des revendications 7 à 16.

18. Peinture selon la revendication 17, **caractérisée en ce que** l'application et le séchage sur le support de la ou des couches de ladite composition sont réalisées à une température de 18 à 24°C et sous une hygrométrie relative inférieure à 60%.

19. Peinture selon la revendication 17 ou la revendication 18, **caractérisée en ce qu'**elle présente une résistivité surfacique de 10⁵ à 10⁹ Ω/carré.

20. Utilisation d'une composition selon l'une quelconque des revendications 7 à 16 ou d'une peinture selon l'une quelconque des revendications 17 à 19 pour faciliter l'écoulement des charges électrostatiques sur la surface externe d'un avion ou d'un engin spatial, et notamment d'un lanceur spatial.

21. Utilisation selon la revendication 20 pour faciliter l'écoulement des charges électrostatiques sur la surface externe d'une structure cryogénique, et notamment d'un réservoir.

## Revendications (Revendications pour l'(les) Etat(s) contractant(s) suivant(s): AT, BE, BG, CH, CY, CZ, DK, EE, ES, FI, FR, GR, HU, IE, IT, LI, LU, MC, NL, PT, RO, SE, SI, SK, TR)

1. Utilisation, dans une composition filmogène, d'au moins un agent tensio-actif cationique pour conférer une résistivité surfacique de 10⁵ à 10⁹ Ω/carré à une peinture ou un vernis obtenu par application et séchage de ladite composition sur un support.

2. Utilisation selon la revendication 1, dans laquelle le ou les agents tensio-actifs cationiques sont choisis dans le groupe constitué par les sels d'ammonium quaternaire.

3. Utilisation selon la revendication 1 ou la revendication 2, dans laquelle le ou les agents tensio-actifs cationiques sont choisis parmi les éthosulfates de N-alkylcocodiméthyléthylammonium.

4. Utilisation selon l'une quelconque des revendications précédentes, dans laquelle le ou les agents tensio-actifs cationiques sont utilisés en solution dans un solvant organique.

5. Utilisation selon la revendication 4, dans laquelle le solvant organique est choisi parmi les alcools, les éthers de glycol et leurs mélanges.

6. Utilisation selon la revendication 4 ou la revendication 5, dans laquelle le ou les agents tensioactifs cationiques étant utilisés en solution dans un solvant organique, ils représentent au moins 50% (p/p) et, de préférence, au moins 70% (p/p) de cette solution.

7. Utilisation selon l'une quelconque des revendications 4 à 6, dans laquelle, le ou les agents tensio-actifs cationiques étant utilisés en solution dans un solvant organique, on utilise une solution d'éthosulfates de N-alkylcocodiméthyléthylammonium à environ 80% (p/p) dans un mélange butanol/éthylglycol.

8. Composition utile pour la réalisation d'une peinture ou d'un vernis de protection électrostatique, **caractérisée en ce qu'**elle comprend un liant filmogène et au moins un agent tensio-actif cationique dans un solvant organique.

9. Composition selon la revendication 8,
**caractérisée en ce que** le liant filmogène est un liant polyuréthanne à deux composants : une base et un durcisseur, qui sont destinés à être mélangés juste avant emploi de ladite composition, le ou les agents tensio-actifs cationiques étant présents dans la base.

10. Composition selon la revendication 8 ou la revendication 9, **caractérisée en ce que** le ou les agents tensio-actifs cationiques sont choisis dans le groupe constitué par les sels d'ammonium quaternaire.

11. Composition selon l'une quelconque des revendication 8 à 10, **caractérisée en ce que** le ou les agents tensio-actifs cationiques sont choisis parmi les éthosulfates de N-alkylcocodiméthyléthylammonium.

12. Composition selon l'une quelconque des revendications 8 à 11, **caractérisée en ce que** le ou les agents tensio-actifs cationiques sont ajoutés au liant filmogène sous la forme d'une solution dans un solvant organique.

13. Composition selon la revendication 12, **caractérisée en ce que** le solvant organique est choisi parmi les alcools, les éthers de glycol et leurs mélanges.

14. Composition selon l'une quelconque des revendications 9 à 13, **caractérisée en ce qu'**elle comprend, pour 100 parties en poids d'une base polyuréthanne :
- de 70 à 110 parties en poids d'une solution d'éthosulfates de N-alkylcocodiméthyléthylammonium à environ 80% (p/p) dans un mélange butanol/éthylglycol, et
- de 80 à 110 parties en poids d'un durcisseur polyuréthanne.

15. Composition selon la revendication 14, **caractérisée en ce qu'**elle comprend, pour 100 parties en poids d'une base polyuréthanne :
- de 80 à 100 parties en poids d'une solution d'éthosulfates de N-alkylcocodiméthyléthylammonium à environ 80% (p/p) dans un mélange butanol/éthylglycol, et
- de 90 à 100 parties en poids d'un durcisseur polyuréthanne.

16. Composition selon l'une quelconque des revendications 8 à 15, **caractérisée en ce qu'**elle comprend au moins un pigment blanc.

17. Composition selon la revendication 16, **caractérisée en ce que** le pigment blanc est un carbonate de calcium naturel.

18. Peinture de protection électro-statique, **caractérisée en ce qu'**elle est obtenue par application et séchage sur un support d'une ou plusieurs couches d'une composition telle que définie dans l'une quelconque des revendications 8 à 17.

19. Peinture selon la revendication 18, **caractérisée en ce que** l'application et le séchage sur le support de la ou des couches de ladite composition sont réalisées à une température de 18 à 24°C et sous une hygrométrie relative inférieure à 60%.

20. Peinture selon la revendication 18 ou la revendication 20, **caractérisée en ce qu'**elle présente une résistivité surfacique de 10⁵ à 10⁹ Ω/carré.

21. Utilisation d'une composition selon l'une quelconque des revendications 8 à 17 ou d'une peinture selon l'une quelconque des revendications 18 à 20 pour faciliter l'écoulement des charges électrostatiques sur la surface externe d'un avion ou d'un engin spatial, et notamment d'un lanceur spatial.

22. Utilisation selon la revendication 21 pour faciliter l'écoulement des charges électrostatiques sur la surface externe d'une structure cryogénique, et notamment d'un réservoir.

## Claims (Claims for the following Contracting State(s): DE, GB)

1. Use, in a film-forming composition, of at least one cationic surface-active agent in solution in an organic solvent for conferring a surface resistivity of 10⁵ to 10⁹ Ω/square on a paint or a varnish obtained by applying the said composition to and drying the said composition on a support.

2. Use according to Claim 1, in which the cationic surface-active agent or agents are chosen from the group consisting of quaternary ammonium salts.

3. Use according to Claim 1 or Claim 2, in which the cationic surface-active agent or agents are chosen from N-alkylcocodimethylethylammonium ethyl sulphates.

4. Use according to Claim 1, in which the organic solvent is chosen from alcohols, glycol ethers and their mixtures.

5. Use according to Claim 1 or Claim 4, in which the cationic surface-active agent or agents represent at least 50% (w/w) and preferably at least 70% (w/w) of the solution in which they are found.

6. Use according to Claim 4 or Claim 5, in which use is made of an approximately 80% (w/w) solution of N-alkylcocodimethylethylammonium ethyl sulphates in a butanol/ethyl glycol mixture.

7. Composition of use in the preparation of a paint or of a varnish for electrostatic protection, **characterized in that** it comprises a film-forming binder and at least one cationic surface-active agent in an organic solvent.

8. Composition according to Claim 7, **characterized in that** the film-forming binder is a polyurethane binder comprising two components, a base and a hardener, which are intended to be mixed immediately before use of the said composition, the cationic surface-active agent or agents being present in the base.

9. Composition according to Claim 7 or Claim 8, **characterized in that** the cationic surface-active agent or agents are chosen from the group consisting of quaternary ammonium salts.

10. Composition according to any one of Claims 7 to 9, **characterized in that** the cationic surface-active agent or agents are chosen from N-alkylcocodimethylethylammonium ethyl sulphates.

11. Composition according to any one of Claims 7 to 10, **characterized in that** the cationic surface-active agent or agents are added to the film-forming binder in the form of a solution in an organic solvent.

12. Composition according to Claim 11, **characterized in that** the organic solvent is chosen from alcohols, glycol ethers and their mixtures.

13. Composition according to any one of Claims 8 to 12, **characterized in that** it comprises, per 100 parts by weight of a polyurethane base:
- from 70 to 110 parts by weight of an approximately 80% (w/w) solution of N-alkylcocodimethylethylammonium ethyl sulphates in a butanol/ethyl glycol mixture, and
- from 80 to 110 parts by weight of a polyurethane hardener.

14. Composition according to Claim 13, **characterized in that** it comprises, per 100 parts by weight of a polyurethane base:
- from 80 to 100 parts by weight of an approximately 80% (w/w) solution of N-alkylcocodimethylethylammonium ethyl sulphates in a butanol/ethyl glycol mixture, and
- from 90 to 100 parts by weight of a polyurethane hardener.

15. Composition according to any one of Claims 7 to 14, **characterized in that** it comprises at least one white pigment.

16. Composition according to Claim 15, **characterized in that** the white pigment is a natural calcium carbonate.

17. Paint for electrostatic protection, **characterized in that** it is obtained by application to and drying on a support of one or more layers of a composition as defined in any one of Claims 7 to 16.

18. Paint according to Claim 17, **characterized in that** the application to and the drying on the support of the layer or layers of the said composition are carried out at a temperature of 18 to 24°C and under a relative humidity of less than 60%.

19. Paint according to Claim 17 or Claim 18, **characterized in that** it exhibits a surface resistivity of 10⁵ to 10⁹ Ω/square.

20. Use of a composition according to any one of Claims 7 to 16 or of a paint according to any one of Claims 17 to 19 for facilitating the flow of electrostatic charges over the external surface of an aircraft or of a spacecraft and in particular of a space launcher.

21. Use according to Claim 20 for facilitating the flow of electrostatic charges over the external surface of a cryogenic structure and in particular of a tank.

## Claims (Claims for the following Contracting State(s): AT, BE, BG, CH, CY, CZ, DK, EE, ES, FI, FR, GR, HU, IE, IT, LI, LU, MC, NL, PT, RO, SE, SI, SK, TR)

1. Use, in a film-forming composition, of at least one cationic surface-active agent for conferring a surface resistivity of 10⁵ to 10⁹ Ω/square on a paint or a varnish obtained by applying the said composition to and drying the said composition on a support.

2. Use according to Claim 1, in which the cationic surface-active agent or agents are chosen from the group consisting of quaternary ammonium salts.

3. Use according to Claim 1 or Claim 2, in which the cationic surface-active agent or agents are chosen from N-alkylcocodimethylethylammonium ethyl sulphates.

4. Use according to any one of the preceding claims, in which the cationic surface-active agent or agents are used in solution in an organic solvent.

5. Use according to Claim 4, in which the organic solvent is chosen from alcohols, glycol ethers and their mixtures.

6. Use according to Claim 4 or Claim 5, in which, the cationic surface-active agent or agents being used in solution in an organic solvent, they represent at least 50% (w/w) and preferably at least 70% (w/w) of this solution.

7. Use according to any one of Claims 4 to 6, in which, the cationic surface-active agent or agents being used in solution in an organic solvent, use is made of an approximately 80% (w/w) solution of N-alkylcocodimethylethylammonium ethyl sulphates in a butanol/ethyl glycol mixture.

8. Composition of use in the preparation of a paint or of a varnish for electrostatic protection, **characterized in that** it comprises a film-forming binder and at least one cationic surface-active agent in an organic solvent.

9. Composition according to Claim 8, **characterized in that** the film-forming binder is a polyurethane binder comprising two components, a base and a hardener, which are intended to be mixed immediately before use of the said composition, the cationic surface-active agent or agents being present in the base.

10. Composition according to Claim 8 or Claim 9, **characterized in that** the cationic surface-active agent or agents are chosen from the group consisting of quaternary ammonium salts.

11. Composition according to any one of Claims 8 to 10, **characterized in that** the cationic surface-active agent or agents are chosen from N-alkylcocodimethylethylammonium ethyl sulphates.

12. Composition according to any one of Claims 8 to 11, **characterized in that** the cationic surface-active agent or agents are added to the film-forming binder in the form of a solution in an organic solvent.

13. Composition according to Claim 12, **characterized in that** the organic solvent is chosen from alcohols, glycol ethers and their mixtures.

14. Composition according to any one of Claims 9 to 13, **characterized in that** it comprises, per 100 parts by weight of a polyurethane base:
- from 70 to 110 parts by weight of an approximately 80% (w/w) solution of N-alkylcocodimethylethylammonium ethyl sulphates in a butanol/ethyl glycol mixture, and
- from 80 to 110 parts by weight of a polyurethane hardener.

15. Composition according to Claim 14, **characterized in that** it comprises, per 100 parts by weight of a polyurethane base:
- from 80 to 100 parts by weight of an approximately 80% (w/w) solution of N-alkylcocodimethylethylammonium ethyl sulphates in a butanol/ethyl glycol mixture, and
- from 90 to 100 parts by weight of a polyurethane hardener.

16. Composition according to any one of Claims 8 to 15, **characterized in that** it comprises at least one white pigment.

17. Composition according to Claim 16, **characterized in that** the white pigment is a natural calcium carbonate.

18. Paint for electrostatic protection, **characterized in that** it is obtained by application to and drying on a support of one or more layers of a composition as defined in any one of Claims 8 to 17.

19. Paint according to Claim 18, **characterized in that** the application to and the drying on the support of the layer or layers of the said composition are carried out at a temperature of 18 to 24°C and under a relative humidity of less than 60%.

20. Paint according to Claim 18 or Claim 19, **characterized in that** it exhibits a surface resistivity of 10⁵ to 10⁹ Ω/square.

21. Use of a composition according to any one of Claims 8 to 17 or of a paint according to any one of Claims 18 to 20 for facilitating the flow of electrostatic charges over the external surface of an aircraft or of a spacecraft and in particular of a space launcher.

22. Use according to Claim 21 for facilitating the flow of electrostatic charges over the external surface of a cryogenic structure and in particular of a tank.

## Patentansprüche (Patentansprüche für folgende(n) Vertragsstaat(en): DE, GB)

1. Verwendung wenigstens eines kationischen tensioaktiven Mittels in Lösung in einem organischen Lösungsmittel in einer filmogenen Zusammensetzung, um einer Farbe oder einem Lack, erhalten durch Aufbringen und Trocknen der Zusammensetzung auf einem Träger, eine Oberflächenresistivität von 10⁵ bis 10⁹ Ω/Quadrat zu verleihen.

2. Verwendung nach Anspruch 1, wobei das oder die kationischen tensioaktiven Mittel ausgewählt sind aus der Gruppe gebildet durch die quaternären Ammoniumsalze.

3. Verwendung nach Anspruch 1 oder Anspruch 2, wobei das oder die kationischen tensioaktiven Mittel ausgewählt sind aus den Ethosulfaten von N-Alkylcocodimethylethylammonium.

4. Verwendung nach Anspruch 1, wobei das organische Lösungsmittel ausgewählt ist aus den Alkoholen, den Glykoläthern und ihren Mischungen.

5. Verwendung nach Anspruch 1 oder Anspruch 4, wobei das oder die kationischen tensioaktiven Mittel wenigstens 50 % (p/p) und vorzugsweise wenigstens 70 % (p/p) der Lösung darstellen, in der sie sich befinden.

6. Verwendung nach Anspruch 4 oder Anspruch 5, wobei man eine Lösung von Ethosulfaten von N-Alkylcocodimethylethylammonium zu ungefähr 80 % (p/p) in einer Butanol/Ethylglykol-Mischung verwendet.

7. Zusammensetzung für die Herstellung einer Elektrostatikschutzfarbe oder -lacks, **dadurch gekennzeichnet, dass** sie einen filmogenen Binder und wenigstens ein kationisches tensioaktives Mittel in einem organischen Lösungsmittel umfasst.

8. Zusammensetzung nach Anspruch 7, **dadurch gekennzeichnet, dass** der filmogene Binder ein Polyurethan-Binder mit zwei Bestandteilen ist, nämlich einer Base und einem Härtemittel, die dazu bestimmt sind, unmittelbar vor der Verwendung der Zusammensetzung gemischt zu werden, wobei das oder die kationischen tensioaktiven Mittel in der Base vorhanden sind.

9. Zusammensetzung nach Anspruch 7 oder Anspruch 8, **dadurch gekennzeichnet, dass** das oder die kationischen tensioaktiven Mittel ausgewählt sind aus der Gruppe gebildet durch die quaternären Ammoniumsalze.

10. Zusammensetzung nach einem der Ansprüche 7 - 9, **dadurch gekennzeichnet, dass** das oder die kationischen tensioaktiven Mittel ausgewählt sind aus den Ethosulfaten von N-Alkylcocodimethylethylammonium.

11. Zusammensetzung nach einem der Ansprüche 7 - 10, **dadurch gekennzeichnet, dass** das oder die kationischen tensioaktiven Mittel dem filmogenen Binder in Form einer Lösung in einem organischen Lösungsmittel hinzugefügt werden.

12. Zusammensetzung nach Anspruch 11, **dadurch gekennzeichnet, dass** das organische Lösungsmittel ausgewählt ist aus den Alkoholen, den Glykoläthern und ihren Mischungen.

13. Zusammensetzung nach einem der Ansprüche 8 - 12, **dadurch gekennzeichnet, dass** sie auf 100 Gewichtsanteile einer Polyurethan-Base folgendes umfasst:
- von 70-110 Gewichtsanteile einer Lösung von Ethosulfaten von N-Alkylcocodimethylethylammonium bei ungefähr 80 % (p/p) in einer Butanol/Ethylglykol-Mischung, und
- von 80 - 110 Gewichtsanteile eines Polyurethan-Härtemittels.

14. Zusammensetzung nach Anspruch 13, **dadurch gekennzeichnet, dass** sie auf 100 Gewichtsanteile einer Polyurethan-Base folgendes umfasst:
- von 80 - 100 Gewichtsanteile einer Lösung von Ethosulfaten von N-Alkylcocodimethylethylammonium bei ungefähr 80 % (p/p) in einer Butanol/Ethylglykol-Mischung, und
- von 90 - 100 Gewichtsanteile eines Polyurethan-Härtemittels.

15. Zusammensetzung nach einem der Ansprüche 7 - 14, **dadurch gekennzeichnet, dass** sie wenigstens ein weißes Pigment umfasst.

16. Zusammensetzung nach Anspruch 15, **dadurch gekennzeichnet, dass** das weiße Pigment ein natürliches Kalciumkarbonat ist.

17. Elektrostatikschutzfarbe, **dadurch gekennzeichnet, dass** sie durch Auftragen und Trocknen einer oder mehrerer Schichten einer Zusammensetzung, wie sie in einem der Ansprüche 7 - 16 definiert ist, auf einen Träger erhalten ist.

18. Farbe nach Anspruch 17, **dadurch gekennzeichnet, dass** das Auftragen und das Trocknen des oder der Schichten der Zusammensetzung auf den Träger bei einer Temperatur von 18 - 24°C und bei einer relativen Luftfeuchtigkeit von weniger als 60 % erfolgt.

19. Farbe nach Anspruch 17 oder Anspruch 18, **dadurch gekennzeichnet, dass** sie eine Oberflächenresistivität von 10⁵ bis 10⁹ Ω/Quadrat aufweist.

20. Verwendung einer Zusammensetzung nach einem der Ansprüche 7 - 16 oder einer Farbe nach einem der Ansprüche 17 - 19 zur Erleichterung des Fließens von elektrostatischen Ladungen auf der äußeren Oberfläche eines Flugzeugs oder eines Raumfahrzeugs, und insbesondere einer Raumfahrt-Trägerrakete.

21. Verwendung nach Anspruch 20 zur Erleichterung des Fließens von elektrostatischen Ladungen auf der äußeren Oberfläche einer kryogenen Struktur, und insbesondere eines Behälters.

## Patentansprüche (Patentansprüche für folgende(n) Vertragsstaat(en): AT, BE, BG, CH, CY, CZ, DK, EE, ES, FI, FR, GR, HU, IE, IT, LI, LU, MC, NL, PT, RO, SE, SI, SK, TR)

1. Verwendung wenigstens eines kationischen tensioaktiven Mittels in einer filmogenen Zusammensetzung, um einer Farbe oder einem Lack, erhalten durch Aufbringen und Trocknen der Zusammensetzung auf einem Träger, eine Oberflächenresistivität von 10⁵ bis 10⁹ Ω/Quadrat zu verleihen.

2. Verwendung nach Anspruch 1, wobei das oder die kationischen tensioaktiven Mittel ausgewählt sind aus der Gruppe gebildet durch die quaternären Ammoniumsalze.

3. Verwendung nach Anspruch 1 oder Anspruch 2, wobei das oder die kationischen tensioaktiven Mittel ausgewählt sind aus den Ethosulfaten von N-Alkylcocodimethylethylammonium.

4. Verwendung nach einem der vorhergehenden Ansprüche, wobei das oder die kationischen tensioaktiven Mittel in Lösung in einem organischen Lösungsmittel verwendet werden.

5. Verwendung nach Anspruch 4, wobei das organische Lösungsmittel ausgewählt ist aus den Alkoholen, den Glykoläthern und ihren Mischungen.

6. Verwendung nach Anspruch 4 oder Anspruch 5, wobei das oder die kationischen tensioaktiven Mittel in Lösung in einem organischen Lösungsmittel verwendet werden und wenigstens 50 % (p/p) und vorzugsweise wenigstens 70 % (p/p) dieser Lösung darstellen.

7. Verwendung nach einem der Ansprüche 4-6, wobei das oder die kationischen tensioaktiven Mittel in Lösung in einem organischen Lösungsmittel verwendet werden, und man eine Lösung von Ethosulfaten von N-Alkylcocodimethylethylammonium bei ungefähr 80 % (p/p) in einer Butanol/Ethylglykol-Mischung verwendet.

8. Zusammensetzung für die Herstellung einer Elektrostatikschutzfarbe oder -lacks, **dadurch gekennzeichnet, dass** sie einen filmogenen Binder und wenigstens ein kationisches tensioaktives Mittel in einem organischen Lösungsmittel umfasst.

9. Zusammensetzung nach Anspruch 8, **dadurch gekennzeichnet, dass** der filmogene Binder ein Polyurethan-Binder mit zwei Bestandteilen ist, nämlich einer Base und einem Härtemittel, die dazu bestimmt sind, unmittelbar vor der Verwendung der Zusammensetzung gemischt zu werden, wobei das oder die kationischen tensioaktiven Mittel in der Base vorhanden sind.

10. Zusammensetzung nach Anspruch 8 oder Anspruch 9, **dadurch gekennzeichnet, dass** das oder die kationischen tensioaktiven Mittel ausgewählt sind aus der Gruppe gebildet durch die quaternären Ammoniumsalze.

11. Zusammensetzung nach einem der Ansprüche 8 - 10, **dadurch gekennzeichnet, dass** das oder die kationischen tensioaktiven Mittel ausgewählt sind aus den Ethosulfaten von N-Alkylcocodimethylethylammonium.

12. Zusammensetzung nach einem der Ansprüche 8-11, **dadurch gekennzeichnet, dass** das oder die kationischen tensioaktiven Mittel dem filmogenen Binder in Form einer Lösung in einem organischen Lösungsmittel hinzugefügt werden.

13. Zusammensetzung nach Anspruch 12, **dadurch gekennzeichnet, dass** das organische Lösungsmittel ausgewählt ist aus den Alkoholen, den Glykoläthern und ihren Mischungen.

14. Zusammensetzung nach einem der Ansprüche 9 - 13, **dadurch gekennzeichnet, dass** sie auf 100 Gewichtsanteile einer Polyurethan-Base folgendes umfasst:
- von 70-110 Gewichtsanteile einer Lösung von Ethosulfaten von N-Alkylcocodimethylethylammonium bei ungefähr 80 % (p/p) in einer Butanol/Ethylglykol-Mischung, und
- von 80 - 110 Gewichtsanteile eines Polyurethan-Härtemittels.

15. Zusammensetzung nach Anspruch 14, **dadurch gekennzeichnet, dass** sie auf 100 Gewichtsanteile einer Polyurethan-Base folgendes umfasst:
- von 80-100 Gewichtsanteile einer Lösung von Ethosulfaten von N-Alkylcocodimethylethylammonium bei ungefähr 80 % (p/p) in einer Butanol/Ethylglykol-Mischung, und
- von 90 - 100 Gewichtsanteile eines Polyurethan-Härtemittels.

16. Zusammensetzung nach einem der Ansprüche 8-15, **dadurch gekennzeichnet, dass** sie wenigstens ein weißes Pigment umfasst.

17. Zusammensetzung nach Anspruch 16, **dadurch gekennzeichnet, dass** das weiße Pigment ein natürliches Kalciumkarbonat ist.

18. Elektrostatikschutzfarbe, **dadurch gekennzeichnet, dass** sie durch Auftragen und Trocknen einer oder mehrerer Schichten einer Zusammensetzung, wie sie in einem der Ansprüche 8 - 17 definiert ist, auf einen Träger erhalten ist.

19. Farbe nach Anspruch 18, **dadurch gekennzeichnet, dass** das Auftragen und das Trocknen des oder der Schichten der Zusammensetzung auf den Träger bei einer Temperatur von 18 - 24°C und bei einer relativen Luftfeuchtigkeit von weniger als 60 % erfolgt.

20. Farbe nach Anspruch 18 oder Anspruch 19, **dadurch gekennzeichnet, dass** sie eine Oberflächenresistivität von 10⁵ bis 10⁹ Ω/Quadrat aufweist.

21. Verwendung einer Zusammensetzung nach einem der Ansprüche 8 - 17 oder einer Farbe nach einem der Ansprüche 18 - 20 zur Erleichterung des Fließens von elektrostatischen Ladungen auf der äußeren Oberfläche eines Flugzeugs oder eines Raumfahrzeugs, und insbesondere einer Raumfahrt-Trägerrakete.

22. Verwendung nach Anspruch 21 zur Erleichterung des Fließens von elektrostatischen Ladungen auf der äußeren Oberfläche einer kryogenen Struktur, und insbesondere eines Behälters.
